# FASCICULE DE BREVET EUROPEEN

(11) **EP 2 907 176 B1**
(45) Date de publication et mention de la délivrance du brevet: **04.04.2018**
(21) Numéro de dépôt: 13773814.2
(22) Date de dépôt: 09.10.2013
(51) Int. Cl.: H01M 2/10, B60R 16/04

(54) **COFFRE ETANCHE POUR BATTERIES ALCALINES**
ABGEDICHTETES GEHÄUSE FÜR ALKALIBATTERIEN
LEAKTIGHT BOX FOR ALKALINE BATTERIES

(30) Priorité: 10.10.2012 FR 1259680
(43) Date de publication de la demande: 19.08.2015
(73) Titulaire: SAFT, 93170 Bagnolet (FR)
(72) Inventeur: VASTI, Philippe, F-33320 Le Taillan Medoc (FR); TRIDON, Xavier, F-33000 Bordeaux (FR)
(74) Mandataire: Hirsch & Associés
(86) Numéro de dépôt international: PCT/EP2013/071086
(87) Numéro de publication internationale: WO 2014/056998

(56) Documents cités:
- WO-A1-2011/134828
- US-A1- 2010 136 402
- US-B1- 6 395 417

## Description

### DOMAINE TECHNIQUE

Le domaine technique auquel se rapporte l'invention est celui des coffres utilisés pour stocker des accumulateurs comprenant un électrolyte liquide. L'invention concerne également les procédés de fabrication de tels coffres.

### ETAT DE LA TECHNIQUE

Une batterie d'accumulateurs comprend généralement une pluralité d'accumulateurs électrochimiques disposés côte à côte. Les accumulateurs sont connectés ensemble en série ou en parallèle en fonction de la tension nominale de fonctionnement du consommateur électrique et de la quantité d'énergie qu'il est prévu de fournir à ce consommateur. Pour faciliter le transport et le stockage des accumulateurs constituant la batterie, on les place généralement dans un conteneur commun, encore désigné selon la norme CEI 60050-482 par les termes de coffre de groupement ou de caisse de groupement. Le coffre de groupement est défini comme un conteneur muni d'une plaque de fond et des parois latérales destiné à contenir plusieurs accumulateurs électrochimiques. Un tel coffre est en général constitué principalement d'une pluralité de plaques métalliques assemblées entre elles.

Le coffre de groupement possède une autre fonction que celle de liaison (interfaçage) avec un matériel roulant, tel qu'un matériel ferroviaire, qui est celle de contenir toute fuite d'électrolyte ou de matériau qui pourrait s'échapper d'un ou de plusieurs accumulateurs et éventuellement causer des dommages au matériel situé dans l'espace situé autour de la zone de stockage de la batterie. En effet, l'électrolyte peut être de l'acide dans le cas d'accumulateurs plomb-acide ou être une base forte telle que KOH, LiOH ou NaOH dans le cas d'accumulateurs alcalins. Afin d'éviter toute corrosion du matériel ou de l'espace situé autour de la zone de stockage de la batterie, il est nécessaire que le coffre de groupement soit étanche aux liquides.

Un assemblage par système de vis-écrou est sensible aux vibrations. Celles-ci peuvent provoquer un desserrage du système vis-écrou et conduire à un défaut d'étanchéité.

Le document US 2010/0136402 décrit un coffre pour accumulateurs électrochimiques. Ce coffre comprend un compartiment inférieur et un couvercle. Le compartiment et le couvercle sont assemblés à l'aide de boulons. L'étanchéité à l'humidité est assurée par un joint en caoutchouc butyle qui est inséré et écrasé entre une surface du compartiment inférieur et une surface du couvercle. Les boulons exercent une force de compression qui provoque l'écrasement du joint créant ainsi une zone d'étanchéité à la périphérie du couvercle. La force de compression est calculée de manière à ce qu'elle soit suffisante pour permettre une déformation du joint qui pénètre dans les irrégularités de surface mais inférieure à une certaine limite au-delà de laquelle on observerait un tassement sous compression du joint qui perdra au cours du temps ses propriétés élastiques et ne sera plus étanche.

Le document US 6 395 417 décrit un système de stockage d'accumulateurs électrochimiques comprenant un bac de rétention. Ce bac de rétention comprend un matériau capable d'absorber les fuites d'électrolyte, par exemple de l'acide sulfurique contenu dans des accumulateurs plomb-acide. Le bac de rétention comprend un rail qui peut être fixé au sol ou à une autre structure par l'intermédiaire d'une vis, d'un clou ou de tout autre dispositif de fixation. L'étanchéité est assurée par exemple grâce à un cordon en caoutchouc butyle.

Dans ces deux documents c'est l'association d'un joint en caoutchouc butyle avec un moyen de compression, tel qu'un boulon, qui assure l'étanchéité. Le boulon n'assure pas seul la fonction d'étanchéité.

Le document WO 2011/134828 décrit un coffre à batterie étanche comprenant un fond et des parois assemblées à l'aide de rivets aveugles au niveau de rebords de montage obtenus par pliage. Un joint d'étanchéité peut être interposé entre les zones de recouvrement des parois.

Actuellement, l'assemblage des plaques métalliques, notamment de la plaque de fond et des parois latérales se fait par mécano-soudure, c'est-à-dire par soudure de tôles. Il n'apparait pas envisageable à ce jour d'obtenir un assemblage étanche dans des conditions économiquement viables par une autre technique d'assemblage. Les conditions d'utilisation des coffres de groupement sont en effet particulièrement sévères et l'assemblage doit résister aux milieux corrosifs, à des vibrations intenses, notamment pour des applications dans le domaine des transports (utilisation dans un train). Cependant, la technique d'assemblage par soudure pose les problèmes suivants :
- on a constaté l'apparition possible de fissures ou de points de corrosion au niveau des points de soudure ;
- les paramètres de soudure varient en fonction de la nature des matériaux à souder et doivent donc être adaptés par le soudeur ;
- l'opération de soudure nécessite un personnel qualifié et son prix de revient est relativement élevé ;
- deux matériaux de natures différentes peuvent être incompatibles à la soudure ;
- une mauvaise étanchéité entre deux tôles est parfois observée.

On recherche donc à obvier les inconvénients ci-dessus et à obtenir un coffre de groupement pour accumulateurs à électrolyte alcalin qui soit étanche aux liquides tout en évitant l'utilisation de soudure pour assembler les plaques.

### RESUME DE L'INVENTION

A cet effet l'invention propose un coffre étanche pour batterie à électrolyte alcalin, comprenant un assemblage de plaques métalliques, où :
- une première plaque métallique est percée d'une série de trous dans une zone de recouvrement ;
- une deuxième plaque métallique est percée d'une série de trous disposés en regard de ceux de la première plaque métallique dans la zone de recouvrement ;
- les deux plaques se recouvrent dans la zone de recouvrement et sont assemblées dans cette zone par des rivets aveugles structurels comprenant chacun une tête, une tige et un bulbe ;
- la tête et le bulbe des rivets aveugles structurels appuient sur une surface de chaque plaque s'étendant au-delà de la surface de chaque trou ;
- la tige des rivets aveugles structurels est déformée de manière à occuper de manière étanche substantiellement l'ensemble du volume desdits trous de la première et de la deuxième plaques.

De préférence, un joint élastomère comprenant un matériau choisi parmi un caoutchouc butyle, un terpolymère d'éthylène-propylène-diène et un caoutchouc nitrile, est disposé en continuité de la zone de recouvrement, en contact continu avec la première et la deuxième plaque de manière à compléter l'étanchéité du coffre.

De manière surprenante, il a été découvert que l'utilisation conjointe de rivets avec de préférence des joints élastomère du type de ceux décrits ci-avant permet d'obtenir un coffre offrant une excellente étanchéité ainsi qu'une excellente résistance aux vibrations. En effet, l'opinion générale dans le domaine technique de la fabrication de coffres pour batteries était d'une part que le moyen d'assemblage par rivets ne permettrait de garantir ni une bonne résistance aux vibrations ni une bonne étanchéité et d'autre part qu'il n'existait pas de joint pour coffre métallique qui puisse résister au caractère corrosif de l'électrolyte alcalin. Or, la Demanderesse a observé que le coffre selon l'invention pouvait être soumis à de très fortes vibrations sans que l'on observe une dégradation de la tenue mécanique ou un défaut d'étanchéité. Il peut par exemple être disposé sur la plateforme d'un moyen de transport, tel qu'un train, qui est très sujet aux vibrations.

Les plaques métalliques du coffre selon l'invention peuvent être assemblées sans recourir à des soudures ou à un système de vis-écrou, ce qui simplifie le procédé d'assemblage et diminue également son coût.

La Demanderesse a également observé que lorsque le joint élastomère est tel que décrit ci-avant, l'absorption d'électrolyte par le joint en cas de fuite de l'électrolyte d'un accumulateur contenu dans un coffre est limitée et que le joint n'est pas dégradé par l'électrolyte.

Selon un mode de réalisation, la première plaque est disposée dans la zone de recouvrement vers l'intérieur du coffre et est amenée à être en contact avec l'électrolyte alcalin et la deuxième plaque est disposée dans la zone de recouvrement vers l'extérieur du coffre et n'est pas amenée à être en contact avec l'électrolyte alcalin dans cette zone, et la série de trous de la première plaque dans la zone de recouvrement est disposée au voisinage d'un champ de cette première plaque, et le joint élastomère recouvre ledit champ.

Selon un mode de réalisation, chaque plaque métallique est choisie parmi :
- une plaque plane ;
- une plaque pliée;
- un profilé.

Selon un mode de réalisation, l'assemblage de plaques est obtenu uniquement à l'aide de rivets.

Selon un mode de réalisation, l'assemblage de plaques est dépourvu de soudure.

Selon un mode de réalisation, le joint élastomère comprend un caoutchouc butyle qui est un copolymère d'isobutylène et d'isoprène.

Selon un mode de réalisation, le joint élastomère comprend un caoutchouc nitrile qui est un copolymère de butadiène et d'acrylonitrile.

Selon un mode de réalisation, le joint est préformé.

Selon un mode de réalisation, le joint est disposé en bord de la zone de recouvrement et n'est pas comprimé par l'action des rivets.

Selon un mode de réalisation, le joint est disposé dans la zone de recouvrement entre la première et la deuxième plaque et est comprimé par l'action des rivets.

L'invention a également pour objet un procédé de fabrication d'un coffre étanche pour batterie à électrolyte alcalin comprenant un assemblage de plaques, lequel procédé comprend les étapes de :
- mise à disposition d'une première plaque métallique percée d'une série de trous dans une zone de recouvrement ;
- mise à disposition d'une deuxième plaque métallique percée d'une série de trous destinés à être disposés en regard de ceux de la première plaque métallique dans la zone de recouvrement, les deux plaques étant destinées à se recouvrir dans la zone de recouvrement ;
- assemblage des deux plaques dans la zone de recouvrement à l'aide de rivets aveugles structurels comprenant chacun une tête, une tige et un bulbe de manière à ce que la tête et le bulbe des rivets aveugles structurels appuient sur une surface de chaque plaque s'étendant au-delà de la surface de chaque trou, et à ce que la tige des rivets aveugles structurels soit déformée de manière à occuper de manière étanche substantiellement l'ensemble du volume desdits trous de la première et deuxième plaque ;
- de préférence, mise en place d'un joint élastomère comprenant un matériau choisi parmi un caoutchouc butyle, un terpolymère d'éthylène-propylène-diène et un caoutchouc nitrile, où ledit joint est disposé en continuité de la zone de recouvrement, en contact continu avec la première et la deuxième plaque de manière à compléter l'étanchéité du coffre.

Selon un mode de réalisation, chaque plaque métallique est choisie parmi :
- une plaque plane ;
- une plaque pliée ;
- un profilé.

### DESCRIPTION DES FIGURES

D'autres particularités et avantages de la présente invention apparaîtront à la lecture de la description ci-après d'exemples de réalisation non limitatifs, notamment en référence aux dessins annexés dans lesquels :
La figure 1 représente une vue en perspective d'un coffre 1 de groupement selon l'invention contenant 4 accumulateurs de format cylindrique.
La figure 2 est un agrandissement de la partie supérieure avant du coffre représenté à la figure 1.
La figure 3 est une représentation schématique de la zone d'assemblage entre la plaque métallique 30 formant le fond du coffre et la plaque latérale avant 32 du coffre. Cette vue correspond à une coupe du coffre selon la direction AA' de la figure 1.
La figure 4 est une représentation schématique d'une zone d'assemblage selon la direction de coupe BB' de la figure 2 dans laquelle une première plaque métallique 37 est assemblée à une seconde plaque métallique ayant la forme d'une cornière 40.
La figure 5 est une représentation schématique d'une zone d'assemblage selon la direction de coupe CC' de la figure 2 dans laquelle le retour 35 de la plaque latérale gauche 31 est assemblé avec le retour 37 de la plaque latérale avant 32.

Pour des raisons de clarté, les dimensions des différents éléments représentés sur ces figures ne sont pas nécessairement en proportion avec leurs dimensions réelles. Des références identiques dans les figures correspondent aux mêmes pièces représentées.

### EXPOSE DE MODES DE REALISATION

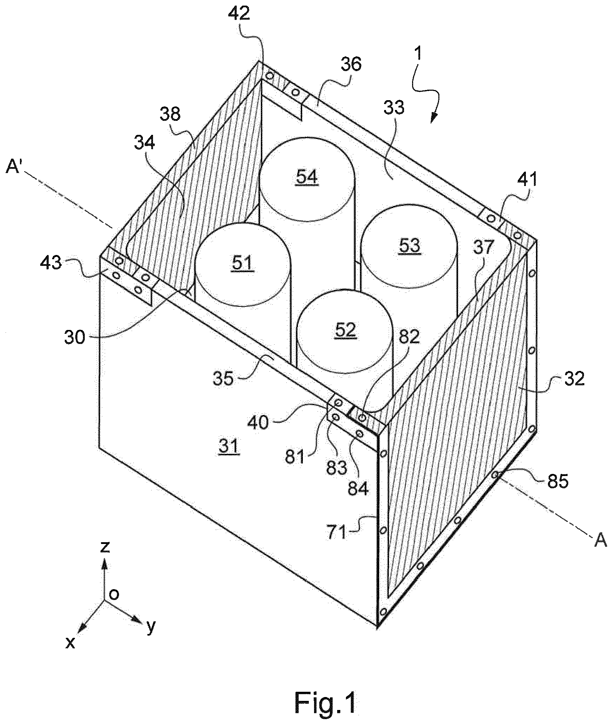

La figure 1 représente une vue en perspective d'un coffre de groupement 1 selon l'invention. Celui-ci se présente sous la forme d'un parallélépipède. Ce parallélépipède comprend une plaque métallique 30 formant un fond sur lequel reposent les accumulateurs (51, 52, 53, 54) et quatre plaques latérales dont une plaque latérale gauche 31, une plaque latérale avant 32, une plaque latérale droite 33 et une plaque latérale arrière 34. La face supérieure du coffre, c'est-à-dire celle opposée au fond, est ouverte pour permettre l'introduction des accumulateurs à l'intérieur du coffre. La partie supérieure des plaques latérales gauche et droite présente un retour (35, 36), qui correspond à la partie du bord supérieur de ces plaques repliée vers l'intérieur du coffre dans une direction sensiblement perpendiculaire à la direction de la plaque. Les extrémités supérieures avant et arrière des plaques gauche 31 et droite 33 présentent chacune des parties dépourvues de retour que l'on appellera évidements sur lesquels viennent s'emboîter les plaques avant 32 et arrière 34 du coffre. Les bords supérieurs de la plaque avant et de la plaque arrière du coffre présentent également chacun un retour (37, 38). La largeur de ce retour est plus élevée à chacune des extrémités de la plaque avant et de la plaque arrière. Ces parties plus larges s'emboîtent dans les évidements des bords supérieurs des plaques latérales gauche et droite. Des cornières (40, 41, 42, 43) permettent d'assurer la fixation des plaques avant 32 et arrière 34 du coffre aux plaques latérales gauche 31 et droite 33. Les plaques sont assemblées à l'aide de rivets aveugles structurels (81, 82, 83, 84) et l'étanchéité est complétée par un joint 71. Les retours 35 et 37 sont assemblés par l'intermédiaire de la cornière 40. Le joint élastomère 71 vient combler d'une part l'espace entre le retour 35 et le retour 37 et d'autre part, l'espace entre le retour 37 et la plaque latérale gauche 31. Le joint élastomère sert également pour compléter l'étanchéité entre la plaque de fond 30 et la plaque avant 32.

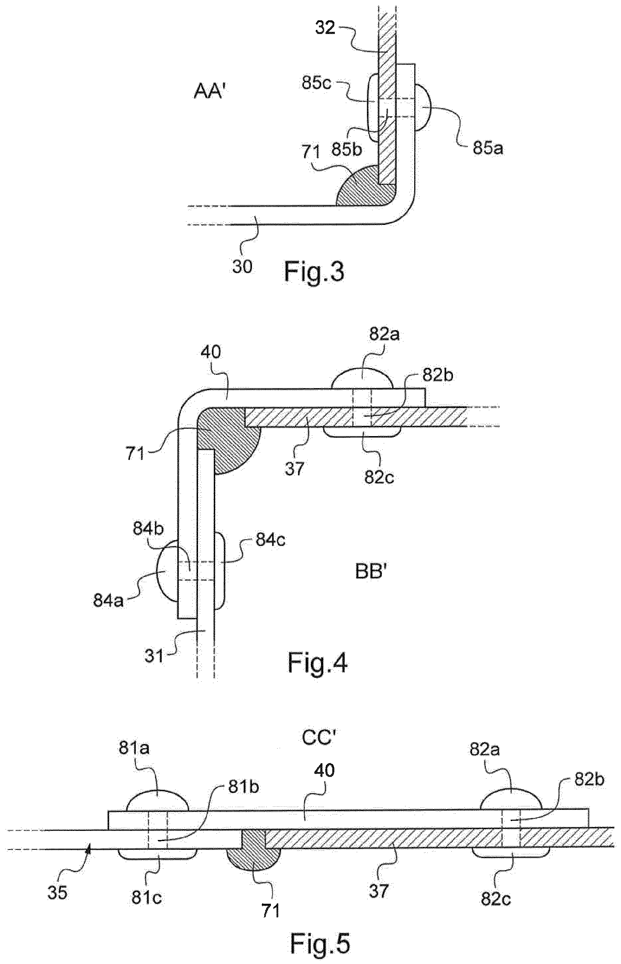

Plusieurs zones d'assemblages peuvent être réalisées et certaines d'entre elles sont détaillées ci-après:
1) une première zone d'assemblage représentée schématiquement à la figure 3 qui correspond à l'assemblage de la plaque du fond 30 avec la plaque avant 32 ;
2) une seconde zone d'assemblage représentée schématiquement à la figure 4 qui correspond à l'assemblage du retour 37 de la plaque avant avec la plaque latérale gauche 31 à l'aide de la cornière 40 ;
3) une troisième zone d'assemblage représentée schématiquement à la figure 5 qui correspond à l'assemblage du retour 35 de la plaque latérale gauche 31 avec le retour 37 de la plaque latérale avant 32 à l'aide de la cornière 40 ;

Les deux premières zones d'assemblage 1) et 2) ci-dessus forment une arête du coffre, tandis que la zone 3) se situe sur l'une des faces du coffre, en l'occurrence la face supérieure du coffre.

Dans le cas où la zone d'assemblage forme une arête du coffre, une première plaque métallique est plane et la seconde plaque métallique peut être soit une plaque pliée, soit un profilé, c'est-à-dire un matériau auquel on a donné une forme déterminée. La plaque pliée peut être en forme de L. Le profilé peut par exemple être une cornière, un tube de section triangulaire ou un tube de section carrée. Dans le cas où la deuxième plaque est une plaque pliée ou une cornière, la zone de pliure de la seconde plaque correspond à l'une des arêtes du coffre.

Dans un premier mode de réalisation illustré à la figure 3, une première plaque 32 est assemblée avec une seconde plaque 30 qui a été préalablement pliée pour former un angle substantiellement droit. La première plaque est la plaque latérale avant 32 du coffre et la seconde plaque préalablement pliée est la plaque du fond 30 du coffre. La figure 3 représente les deux plaques vues dans le sens de leur épaisseur. La vue de la figure 3 correspond à une coupe selon l'axe AA' matérialisé sur la figure 1. Une extrémité de la première plaque 32 est percée d'une série de trous. Le diamètre et l'espacement de ces trous ont été préalablement déterminés par exemple selon le procédé de conception tel que décrit ci-après. Une extrémité de la seconde plaque est également percée de trous dont le diamètre et l'espacement sont identiques à ceux de la première plaque. La série de trous de la première plaque coïncide avec la série de trous de la deuxième plaque. La portion d'extrémité de la première plaque en contact avec la portion d'extrémité de la seconde plaque définit la zone de recouvrement. Les deux plaques sont maintenues en contact l'une avec l'autre pendant que la tige 85b d'un rivet aveugle structurel est insérée dans chaque trou. La tête 85a du rivet correspond à l'extrémité de la tige de plus grande section qui s'appuie sur la plaque métallique 30. Sur la figure 3, le rivet est introduit dans le trou depuis l'extérieur du coffre, c'est-à-dire en traversant d'abord la deuxième plaque, puis il traverse la première plaque et l'extrémité de la tige du rivet dépasse à l'intérieur du coffre. On pourrait envisager à l'inverse d'introduire la tige du rivet depuis l'intérieur du coffre de manière à ce que la tête du rivet s'appuie sur la plaque faisant face à l'intérieur du coffre. L'extrémité de la tige opposée à la tête dépasserait alors à l'extérieur du coffre. L'extrémité de la tige opposée à la tête est ensuite déformée et aplatie contre la surface de l'une des deux plaques. L'extrémité de la tige opposée à la tête est appelée bulbe 85c : il s'agit de la partie de la tige déformée à l'assemblage qui se trouve hors du trou. La déformation de l'extrémité de la tige pour former le bulbe permet d'assembler les deux plaques par compression. Au cours du rivetage, il se produit une déformation de la tige des rivets qui vient occuper de manière étanche presque complètement l'espace formé par l'accolement des deux trous en coïncidence. Ceci permet de rendre étanche la zone de recouvrement à toute fuite de liquide. L'espacement et le diamètre des trous déterminés au cours du procédé de conception permettent d'obtenir une étanchéité du coffre aux liquides. L'intervalle entre deux rivets dépend de la rigidité recherchée pour la zone d'assemblage, de l'épaisseur des plaques et de la nature du rivet. Les rivets utilisés peuvent être choisis parmi :
- un rivet classique
- un rivet aveugle
- un rivet aveugle structurel
- un rivet à anneau (rivelon).

Le diamètre de la tige du rivet est généralement compris entre 1 et 5 mm. La distance minimale entre les axes des tiges de deux rivets voisins est en général au moins égale à 2,5 fois le diamètre de la tige des rivets. La valeur de 2,5 est courante dans le domaine du rivetage et correspond à un bon compromis entre la quantité de matière et un assemblage de solidité satisfaisante.

Un opérateur peut poser un rivet en ayant uniquement accès à un seul côté de la plaque, contrairement à un procédé d'assemblage à l'aide d'un boulon qui nécessite que l'opérateur ait accès aux deux côtés de la plaque pour y poser l'écrou et la vis. Le procédé d'assemblage par rivets offre donc une meilleure accessibilité.

Afin de compléter l'étanchéité conférée par les rivets, on place une fois l'opération de rivetage terminée, un joint élastomère 71 de composition spécifique détaillée ci-après, en contact avec le champ de la première plaque et la zone de pliure de la seconde plaque. L'étanchéité déjà apportée par les rivets est renforcée par la présence du joint car celui-ci empêche toute infiltration d'électrolyte dans la zone de recouvrement, c'est-à-dire entre la face de la première plaque tournée vers l'extérieur du coffre et la face de la seconde plaque tournée vers l'intérieur du coffre. Ceci permet donc d'éviter toute dégradation ultérieure du rivet en cas de fuite d'électrolyte. L'étanchéité est assurée par la seule présence des rivets. La présence du joint est optionnelle.

Le joint est placé une fois l'opération de rivetage terminée. Il n'est donc pas comprimé par l'action des rivets. Il ne se déforme pas, comme cela serait le cas s'il était comprimé par un écrou et une vis.

Dans un second mode de réalisation illustré à la figure 4, la deuxième plaque métallique est un profilé tel qu'une cornière 40 présentant deux branches en forme de L. On assemble le retour 37 de la plaque avant à la branche horizontale de la cornière à l'aide d'une série de rivets, dont un seul 82 est représenté figure 4, selon le procédé décrit précédemment. Le rivet 82 présente une tête 82a, une tige 82b et un bulbe 82c qui correspond à la partie de la tige déformée à l'assemblage hors du trou. Puis, on assemble une troisième plaque métallique 31 à la branche verticale de la cornière à l'aide d'une série de rivets, dont un seul 84 est représenté figure 4, selon le même procédé. Le rivet 84 présente une tête 84a, une tige 84b et un bulbe 84c. La première plaque métallique 37 est donc assemblée à la troisième plaque métallique 31 par l'intermédiaire d'un profilé ayant la forme d'une cornière 40. Enfin, pour renforcer l'étanchéité au niveau d'une part de la zone de recouvrement du retour 37 avec la branche horizontale de la cornière et d'autre part de la branche verticale de la cornière avec la troisième plaque métallique, on place un joint élastomère de manière à ce qu'il soit en contact avec le champ du retour 37, le champ de la troisième plaque 31 et l'arête de la cornière 40, c'est-à-dire le point de jonction des deux branches de la cornière.

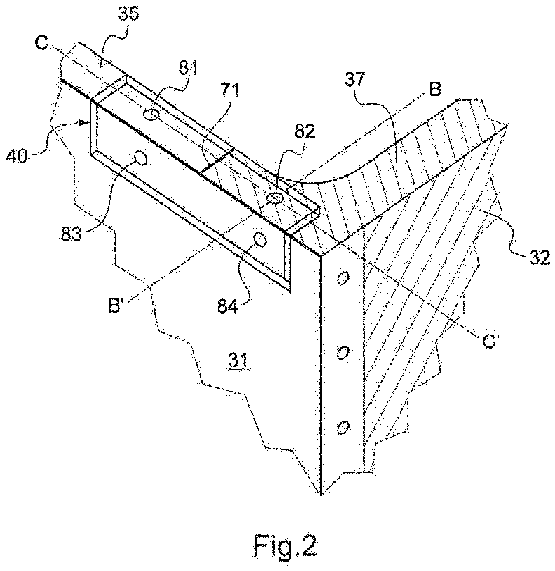

Dans un troisième mode de réalisation, on peut envisager d'assembler deux plaques s'étendant dans des directions sensiblement parallèles. Ce mode de réalisation est représenté à la Figure 5 qui représente une vue selon l'axe CC' de la figure 2. Dans ce cas, la première plaque est constituée par le retour 35 de la plaque 31 et la deuxième plaque est constituée par la branche horizontale de la cornière 40. On procède à l'assemblage du retour 35 à la branche horizontale de la cornière à l'aide d'un rivet 81 selon le même procédé que celui décrit précédemment. Le rivet 81 présente une tête 81a, une tige 81b et un bulbe 81c. Une troisième plaque métallique 37 constituée par le retour de la plaque de la face avant 32 peut également être assemblée à la branche horizontale de la cornière à l'aide d'un rivet 82. Un joint élastomère 71 est ensuite placé au contact du champ du retour 35, du champ du retour 37 et de la surface de la branche horizontale de la cornière 40 tournée vers l'intérieur du coffre.

De préférence, le joint élastomère est disposé en continuité de la zone de recouvrement, en contact continu avec la première et la deuxième plaque. Ceci peut correspondre à un mode de réalisation tel que représenté aux figures 3, 4 et 5 dans lequel le joint est disposé au contact du champ de la première plaque et au contact de la face de la seconde plaque tournée vers l'intérieur du coffre, c'est-à-dire en contact avec l'électrolyte. Il est également possible de disposer le joint entre la surface de la première plaque non exposée à l'électrolyte et la surface de la deuxième plaque exposée à l'électrolyte. Le joint est alors maintenu en compression entre les deux plaques. Ce mode de réalisation est cependant moins préféré que celui illustré aux figures 3, 4 et 5 car le joint est alors soumis à une force de compression sous l'effet du rivetage, ce qui risque de l'endommager.

Il a été découvert que l'utilisation d'un joint élastomère comprenant un matériau choisi parmi un caoutchouc butyle, un terpolymère obtenu par polymérisation de monomères d'éthylène-propylène-diène (EPDM) et un caoutchouc nitrile permet de limiter l'absorption d'électrolyte liquide par le joint.

On entend par le terme générique de caoutchouc butyle tout copolymère de l'isobutylène et de l'isoprène. Les caoutchoucs butyle résultent de la copolymérisation de l'isobutylène H₂C=C(CH₃)₂ avec l'isoprène H₂C=C(CH₃)-CH=CH₂ pour former le copolymère de formule suivante :

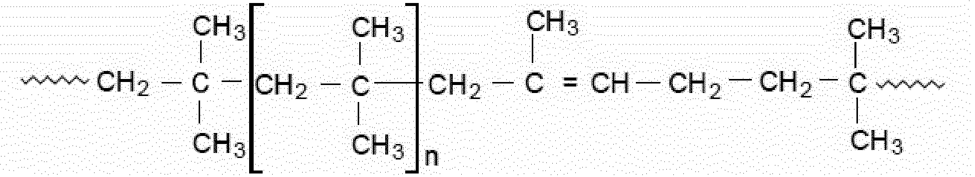

Le solvant de copolymérisation entre l'isobutylène et l'isoprène est le chlorure de méthyle CH₃Cl et la réaction est catalysée par une solution de chlorure d'aluminium AlCl₃ dans ce même solvant. La polymérisation met en jeu 98 % d'isobutylène avec 2 % d'isoprène. L'utilisation d'un caoutchouc butyle permet d'éviter la dégradation du joint par l'électrolyte.

De préférence, le joint comprend au moins 10% en poids d'un copolymère de l'isobutylène avec de l'isoprène.

Dans un mode de réalisation, le joint comprend moins de 50% en poids d'un copolymère de l'isobutylène avec l'isoprène, de préférence de 15 à 25% en poids.

Le joint peut encore comprendre en mélange avec le caoutchouc butyle un ou plusieurs des composés suivants :
- du 1-polybutène, en une quantité allant de préférence de 10 à 50 % en poids du joint;
- du kaolin, en une quantité allant de préférence de 10 à 50 % en poids du joint;
- un ester glycérique de colophane hydrogénée en une quantité allant de préférence de 1 à 10 % en poids du joint;
- une charge telle que le noir de carbone en une quantité allant de préférence de 20 à 30 % en poids du joint.

La présence d'une charge permet d'augmenter la viscosité du joint qui se déforme lorsqu'il est mis en place dans le coffre.

Un premier exemple de joint élastomère comprenant un caoutchouc butyle et convenant particulièrement bien à l'invention est disponible commercialement auprès de la société 3M sous la dénomination commerciale Scotch-weld® 5313. Sa composition est la suivante :
- de 30 à 40 % en poids de 1-polybutylène ;
- de 15 à 25 % en poids de copolymère d'isobutylène-isoprène ;
- de 10 à 30 % de Kaolin ;
- de 1 à 5% d'un ester glycérique de colophane hydrogénée ;
- de 20 à 30 % de noir de carbone.

Ce joint est communément utilisé pour réaliser l'étanchéité de vitres dans le domaine automobile.

Un second joint comprenant un caoutchouc butyle et convenant particulièrement bien à l'invention est disponible commercialement auprès de la société Sika sous la dénomination commerciale SikaLastomer®- 710.

Dans un autre mode de réalisation, le joint élastomère comprend un terpolymère éthylène-propylène-diène monomère (EPDM) qui est obtenu en copolymérisant dans des proportions variables l'éthylène (le terpolymère contient généralement de 60 à 85 % de motifs éthylène), le propylène et un diène non conjugué à un faible taux. De préférence, le pourcentage de terpolymère éthylène-propylène-diène monomère (EPDM) dans le joint est supérieur à 50%.

Encore dans un autre mode de réalisation, le joint élastomère comprend un caoutchouc nitrile. On entend par le terme générique de caoutchouc nitrile tout copolymère de butadiène-acrylonitrile dont la formule est donnée ci-dessous :

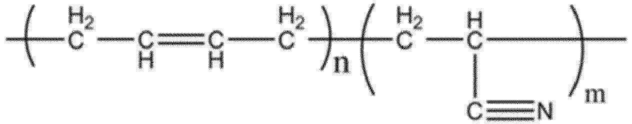

Le copolymère est synthétisé par copolymérisation radicalaire en émulsion du butadiène avec l'acrylonitrile. Le taux d'acrylonitrile est variable et se situe entre 15 et 51 %. De préférence, le pourcentage de copolymère de butadiène-acrylonitrile dans le matériau de joint est supérieur à 50%.

L'utilisation d'un joint tel que défini dans l'invention associé à des rivets aveugles structurels offre les meilleures performances du point de vue solidité et étanchéité. D'une part, ce joint absorbe peu d'électrolyte en cas de fuite d'électrolyte et d'autre part, il résiste bien au caractère corrosif de l'électrolyte et ne vient pas perturber le fonctionnement électrochimique.

De préférence, le joint est préformé, c'est-à-dire qu'il possède une forme prédéterminée avant application sur la zone d'assemblage, cette forme ayant été conférée par le procédé de fabrication du joint, par exemple au cours d'une extrusion.

Des tests ont été effectués afin d'évaluer la résistance de plusieurs matériaux de joint à la corrosivité de l'électrolyte. Plusieurs joints constitués de matériaux de compositions chimiques différentes ont été appliqués sur une plaque en inox préalablement nettoyée à l'acétone. Le joint a été séché pendant une nuit à 70°C. La plaque a été pesée, puis été immergée dans une solution concentrée d'hydroxyde de potassium à pH>14 et mise en vieillissement à 70°C. Après une, deux, quatre et huit semaines, le plaque a été rincée, séchée pendant une nuit à 70°C puis exposée pendant deux heures à la température ambiante. Puis, la variation de masse des joints a été mesurée. Le Tableau ci-dessous récapitule les résultats des essais.

**Tableau 1**

| | **Produit (dénomination commerciale)** | **Fabricant** | **Base chimique** | **Variation de masse (%) en fonction du nombre de semaines** | | | | **Observations** |
|---|---|---|---|---|---|---|---|---|
| | | | | 1 | 2 | 4 | 8 | |
| Exemples comparatifs | Terostat 9220 | Henkel | Polymère à base de silicone modifiée (polymère MS) | | | | | décollement attaque par l'électrolyte |
| | Loctite® 5970™ | Henkel | Silicone à base d'alcool | -32 | -38 | -42 | | décollement |
| | Scotch-weld™ 3789 | 3M | Polyamide thermofusible | | | | | décollement |
| | Scotch-weld™ 3748 | 3M | Polyoléfine thermofusible | | | | | décollement |
| | SAF 400 | AEC polymers | méthacrylate | | | | | désagrégation du joint en moins d'une semaine |
| | Loctite Hysol® 3423 | Henkel | Epoxy bi-composant | - | 7,8 | 11,1 | | décollement en 24h |
| Exemples selon l'invention | Mousse EPDM EC-1200N | Nitto Denko | Mousse éthylène-propylène-diène (EPDM) | -1,3 | -8,3 | -0,2 | | |
| | Mastic lap sealant HS | Firestone | Caoutchouc EPDM | -2,8 | -3,9 | -5,5 | -5,5 | |
| | Scotch-weld™ 5313 | 3M | Caoutchouc butyle préformé | -0,2 | 0,1 | 0,4 | 0,4 | ni décollement ni désagrégation |
| | SikaLastomer®-710 | Sika | Caoutchouc butyle | 0,7 | 2,0 | 0,9 | -0,5 | ni décollement ni désagrégation |

Le tableau 1 montre que :
1) les joints à base de polymère MS, de silicone à base d'alcool, de polyamide thermofusible et de polyoléfine thermofusible, d'époxy bi-composant présentent un décollement ;
2) les joints à base de caoutchouc butyle ou de terpolymère EPDM présentent une faible variation de masse. Ce sont ceux qui absorbent le moins d'électrolyte.
3) les joints à base de caoutchouc butyle tels que le Scotch-weld™ 5313 et le SikaLastomer®-710 présentent en particulier une très bonne résistance à la corrosivité de l'électrolyte ainsi qu'une bonne adhésion à la plaque.

Un coffre dont les plaques métalliques ont été assemblées uniquement à l'aide de rivets et dont l'étanchéité a été complétée par la mise en place d'un joint en butyle préformé a été fabriqué selon un mode de réalisation de l'invention. Les plaques métalliques constituant le coffre sont constituées d'inox d'une épaisseur de 2 à 3 mm et les rivets sont de type rivets aveugles structuraux et rivelons. La résistance de ce coffre aux vibrations a été testée en appliquant le programme de tests suivants :
- détermination de la fréquence de résonance initiale selon la norme NF EN 60068-2-6 (Avril 2008) dans une plage de fréquences allant de 5 à 150 Hz à une vitesse de balayage de 1 oct/min et une accélération de 0,1 g ;
- application de vibrations fonctionnelles aléatoires pendant 10 minutes selon les normes NF EN 61373 catégorie 1, classe B et NF EN 60068-2-64 (Novembre 2008), dans une plage de fréquences allant de 5 à 150 Hz ;
- application de vibrations aléatoires d'endurance pendant 5 heures selon les normes NF EN 61373 catégorie 1, classe B et NF EN 60068-2-64 (Novembre 2008), dans une plage de fréquences allant de 5 à 150 Hz ;
- application de 3 chocs positifs et de 3 chocs négatifs selon les normes NF EN 61373 catégorie 1, classe B et NF EN 60068-2-27 (Juillet 2009). Les chocs positifs et négatifs simulent un choc respectivement dans le sens de la marche normale et dans le sens inverse de la marche normale du véhicule auquel le coffre est fixé. L'onde de choc a une forme de demi sinusoïde ; elle est appliquée pendant 30 ms et l'accélération est de 5 g selon l'axe longitudinal et de 3 g selon l'axe transversal et l'axe vertical ;
- détermination de la fréquence de résonance finale.

Ces tests de vibration ont été appliqués dans les trois axes du coffre, c'est-à-dire selon l'axe transversal, longitudinal et vertical.

La vérification du maintien de la tenue structurelle du coffre a été faite par contrôle visuel et par mesure de la continuité électrique entre différents points du coffre et par la vérification des modes propres de résonnance du coffre. La comparaison entre les valeurs de continuité électrique mesurées avant application des vibrations et après application des vibrations indique de faibles écarts, ce qui montre que le coffre garde une bonne tenue structurelle même après avoir été soumis à de fortes vibrations. Le coffre selon l'invention passe donc avec succès les tests normalisés de résistance aux vibrations. Il peut être monté sur la plateforme d'un engin motorisé, tel qu'un train, sans connaitre de défaut d'étanchéité.

## Revendications

1. Coffre étanche (1) pour batterie (51, 52, 53, 54) à électrolyte alcalin, comprenant un assemblage de plaques métalliques (30, 31, 32, 33, 34), où :
- une première plaque métallique (32) est percée d'une série de trous dans une zone de recouvrement ;
- une deuxième plaque métallique (30) est percée d'une série de trous disposés en regard de ceux de la première plaque métallique dans la zone de recouvrement ;
- les deux plaques se recouvrent dans la zone de recouvrement et sont assemblées dans cette zone par des rivets aveugles structurels comprenant chacun une tête (85a), une tige (85b) et un bulbe (85c);
- la tête et le bulbe des rivets aveugles structurels appuient sur une surface de chaque plaque s'étendant au-delà de la surface de chaque trou ;
- la tige (85b) des rivets aveugles structurels est déformée de manière à occuper de manière étanche substantiellement l'ensemble du volume desdits trous de la première et de la deuxième plaques.

2. Coffre selon la revendication 1, comprenant un joint élastomère (71) comprenant un matériau choisi parmi un caoutchouc butyle, un terpolymère d'éthylène-propylène-diène et un caoutchouc nitrile, où ledit joint est disposé en continuité de la zone de recouvrement, en contact continu avec la première (32) et la deuxième (30) plaque de manière à compléter l'étanchéité du coffre.

3. Coffre selon la revendication 2, **caractérisé en ce que** la première plaque (32) est disposée dans la zone de recouvrement vers l'intérieur du coffre et est amenée à être en contact avec l'électrolyte alcalin et la deuxième plaque (30) est disposée dans la zone de recouvrement vers l'extérieur du coffre et n'est pas amenée à être en contact avec l'électrolyte alcalin dans cette zone, **en ce que** la série de trous de la première plaque dans la zone de recouvrement est disposée au voisinage d'un champ de cette première plaque, et **en ce que** le joint élastomère recouvre ledit champ.

4. Coffre selon la revendication 1,2 ou 3, **caractérisé en ce que** chaque plaque métallique est choisie parmi :
- une plaque plane ;
- une plaque pliée;
- un profilé.

5. Coffre selon l'une des revendications précédentes, dans lequel l'assemblage de plaques (30, 31, 32, 33, 34) est obtenu uniquement à l'aide de rivets aveugles structurels.

6. Coffre selon l'une des revendications précédentes, dans lequel l'assemblage de plaques (30, 31, 32, 33, 34) est dépourvu de soudure.

7. Coffre selon l'une des revendications 2 à 6, dans lequel le joint élastomère comprend un caoutchouc butyle qui est un copolymère d'isobutylène et d'isoprène.

8. Coffre selon l'une des revendications 2 à 6, dans lequel le joint élastomère comprend un caoutchouc nitrile qui est un copolymère de butadiène et d'acrylonitrile.

9. Coffre selon l'une des revendications 2 à 8, dans lequel le joint est préformé.

10. Coffre selon l'une des revendications 2 à 9, dans lequel le joint est disposé en bord de la zone de recouvrement et n'est pas comprimé par l'action des rivets aveugles structurels.

11. Coffre selon l'une des revendications 2 à 9, dans lequel le joint est disposé dans la zone de recouvrement entre la première et la deuxième plaque et est comprimé par l'action des rivets aveugles structurels.

12. Procédé de fabrication d'un coffre étanche (1) pour batterie à électrolyte alcalin (51, 52, 53, 54) comprenant un assemblage de plaques (30, 31, 32, 33, 34), lequel procédé comprend les étapes de :
- mise à disposition d'une première plaque métallique (32) percée d'une série de trous dans une zone de recouvrement ;
- mise à disposition d'une deuxième plaque métallique (30) percée d'une série de trous destinés à être disposés en regard de ceux de la première plaque métallique dans la zone de recouvrement, les deux plaques étant destinées à se recouvrir dans la zone de recouvrement ;
- assemblage des deux plaques dans la zone de recouvrement à l'aide de rivets aveugles structurels comprenant chacun une tête (85a), une tige (85b) et un bulbe (85c) de manière à ce que la tête et le bulbe des rivets aveugles structurels appuient sur une surface de chaque plaque s'étendant au-delà de la surface de chaque trou, et à ce que la tige des rivets aveugles structurels soit déformée de manière à occuper de manière étanche substantiellement l'ensemble du volume desdits trous de la première et deuxième plaque.

13. Procédé selon la revendication 12, comprenant une étape de mise en place d'un joint élastomère (71) comprenant un matériau choisi parmi un caoutchouc butyle, un terpolymère d'éthylène-propylène-diène et un caoutchouc nitrile, où ledit joint est disposé en continuité de la zone de recouvrement, en contact continu avec la première et la deuxième plaque de manière à compléter l'étanchéité du coffre.

14. Procédé de fabrication selon la revendication 12, dans lequel chaque plaque métallique est choisie parmi :
- une plaque plane ;
- une plaque pliée ;
- un profilé.

## Patentansprüche

1. Abgedichtetes Gehäuse (1) für Batterien (51, 52, 53, 54) mit alkalischem Elektrolyten, das eine Anordnung von Metallplatten (30, 31, 32, 33, 34) umfasst, wobei :
- eine erste Metallplatte (32), in einem Überlappungsbereich, von einer Reihe von Löchern durchbohrt ist;
- eine zweite Metallplatte (30) von einer Reihe von Löchern durchbohrt ist, die den Löchern der ersten Metallplatte im Überlappungsbereich gegenüberliegend angeordnet sind;
- die beiden Platten im Überlappungsbereich überlappen und in diesem Bereich durch strukturelle Blindnieten zusammengefügt sind, von denen jede einen Kopf (85a), einen Schaft (85b) und einen Kolben (85c) umfasst;
- Kopf und Kolben der strukturellen Blindnieten auf einer Oberfläche jeder Platte anliegen, die sich über die Oberfläche jedes Loches hinaus erstreckt;
- der Schaft (85b) der strukturellen Blindnieten so verformt ist, dass er im Wesentlichen das gesamte Volumen der Löcher der ersten und zweiten Platte abdichtend einnimmt.

2. Gehäuse nach Anspruch 1, umfassend eine elastomere Dichtung (71), die ein Material umfasst, das ausgewählt ist aus einem Butylkautschuk, einem Ethylen-Propylen-Dien-Terpolymer und einem Nitrilkautschuk, wobei die Dichtung, in Fortsetzung des Überlappungsbereichs, in kontinuierlichem Kontakt mit der ersten (32) und der zweiten (30) Platte angeordnet ist, um somit die Abdichtung des Gehäuses zu ergänzen.

3. Gehäuse nach Anspruch 2, **dadurch gekennzeichnet dass** die erste Platte (32) im Überlappungsbereich zum Inneren des Gehäuses hin angeordnet ist und mit dem alkalischen Elektrolyten in Kontakt gebracht wird, und die zweite Platte (30) im Überlappungsbereich zum Äußeren des Gehäuses hin angeordnet ist und mit dem alkalischen Elektrolyten in diesem Bereich nicht in Kontakt gebracht wird, dass die Reihe der Löcher der ersten Platte im Überlappungsbereich einem Feld der ersten Platte benachbart angeordnet ist, und dass die elastomere Dichtung das Feld abdeckt.

4. Gehäuse nach Ansprüchen 1, 2 oder 3, **dadurch gekennzeichnet dass** jede Metallplatte ausgewählt ist aus:
- einer ebenen Platte;
- einer gefalzten Platte;
- einer Profilplatte.

5. Gehäuse nach einem der vorangehenden Ansprüche, wobei die Anordnung von Platten (30, 31, 32, 33, 34) ausschließlich mithilfe von strukturellen Blindnieten erhalten wird.

6. Gehäuse nach einem der vorangehenden Ansprüche, wobei die Anordnung von Platten (30, 31, 32, 33, 34) frei von Schweißnahten ist.

7. Gehäuse nach einem der Ansprüche 2 bis 6, wobei die elastomere Dichtung einen Butylkautschuk umfasst, der ein Isobutylen-/ und ein Isopren-Copolymer ist.

8. Gehäuse nach einem der Ansprüche 2 bis 6, wobei die elastomere Dichtung einen Nitrilkautschuk umfasst, der ein Butadien-/ und ein Acrylnitril-Copolymer ist.

9. Gehäuse nach einem der Ansprüche 2 bis 8, wobei die Dichtung vorgeformt ist.

10. Gehäuse nach einem der Ansprüche 2 bis 8, wobei die Dichtung am Rande des Überlappungsbereichs angeordnet ist und nicht durch die Wirkung der strukturellen Blindnieten komprimiert wird.

11. Gehäuse nach einem der Ansprüche 2 bis 9, wobei die Dichtung im Überlappungsbereich zwischen der ersten und der zweiten Platte angeordnet ist und durch die Wirkung der strukturellen Blindnieten komprimiert wird.

12. Verfahren zur Herstellung eines abgedichteten Gehäuses (1), für Batterien mit alkalischem Elektrolyten (51, 52, 53, 54), umfassend eine Anordnung von Platten (30, 31, 32, 33, 34), wobei das Verfahren folgende Schritte umfasst:
- Bereitstellen einer ersten Metallplatte (32), die in einem Überlappungsbereich von einer Reihe von Löchern durchbohrt ist;
- Bereitstellen einer zweiten Metallplatte (30), die von einer Reihe von Löchern durchbohrt ist, die dazu vorgesehen sind den Löchern der ersten Metallplatte im Überlappungsbereich gegenüberliegend angeordnet zu sein, wobei beide Platten dazu bestimmt sind, im Überlappungsbereich zu überlappen;
- Anordnung der beiden Platten im Überlappungsbereich, mithilfe von strukturellen Blindnieten, von denen jede einen Kopf (85a), einen Schaft (85b) und einen Kolben (85c) umfasst, so dass Kopf und Kolben der strukturellen Blindnieten auf einer Oberfläche jeder Platte anliegen, die sich über die Oberfläche jedes Loches hinaus erstreckt, und dass der Schaft der strukturellen Blindnieten so verformt ist, dass er im Wesentlichen das gesamte Volumen der Löcher der ersten und zweiten Platte abdichtend einnimmt.

13. Verfahren nach Anspruch 12, umfassend eine elastomere Dichtung (71), die ein Material umfasst, das ausgewählt ist aus einem Butylkautschuk, einem Ethylen-Propylen-Dien-Terpolymer und einem Nitrilkautschuk, wobei die Dichtung, in Fortsetzung des Überlappungsbereichs, in kontinuierlichem Kontakt mit der ersten und der zweiten Platte angeordnet ist, um somit die Abdichtung des Gehäuses zu ergänzen.

14. Verfahren nach Anspruch 12, wobei jede Metallplatte ausgewählt ist aus:
- einer ebenen Platte;
- einer gefalzten Platte;
- einer Profilplatte.

## Claims

1. A leakproof battery tray (1) for an alkaline electrolyte battery (51, 52, 53, 54) comprising an assembly of metal plates (30, 31, 32, 33, 34), in which:
- a first metal plate (32) is provided with a series of holes in an area of overlapping;
- a second metal plate (30) is provided with a series of holes disposed facing those of the first metal plate in the area of overlapping;
- the two plates are overlapped in the area of overlapping and are assembled together in this area by structural blind rivets each having a head (85a), a shank (85b) and upset head (85c);
- the head and upset head of the structural blind rivets abut against a surface of each plate extending beyond the surface area of each hole;
- the shank (85b) of the structural blind rivets is deformed so as to substantially occupy in a sealed manner the entire volume of said holes of the first and second plates.

2. The battery tray according to claim 1, comprising an elastomeric seal (71) comprising a material selected from a butyl rubber, an ethylene-propylene-diene terpolymer and a nitrile rubber, wherein said seal is disposed with continuity at the area of overlapping, in continuous contact with the first (32) and the second (30) plate so as to complete the sealing of the battery tray.

3. The battery tray according to claim 2, **characterized in that** the first plate (32) is disposed in the area of overlapping directed towards the inside of the battery tray and is caused to be in contact with the alkaline electrolyte and the second plate (30) is disposed in the region of overlapping outwardly of the battery tray and is not caused to be in contact with the alkaline electrolyte in this area, **in that** the series of holes in the first plate in the area of overlapping is disposed in the vicinity of an edge of this first plate, and **in that** the elastomeric seal overlies said edge.

4. The battery tray according to claim 1, 2 or 3, **characterized in that** each metal plate is selected from:
- a flat plate;
- a folded plate;
- a shaped plate.

5. The battery tray according to one of the preceding claims, wherein the plate assembly (30, 31, 32, 33, 34) is obtained only with the aid of structural blind rivets.

6. The battery tray according to one of the preceding claims, wherein the plate assembly (30, 31, 32, 33, 34) is devoid of welding.

7. The battery tray according to one of claims 2 to 6, wherein the elastomeric seal comprises a butyl rubber which is a copolymer of isobutylene and isoprene.

8. The battery tray according to one of claims 2 to 6, wherein the elastomeric seal comprises a nitrile rubber which is a copolymer of butadiene and acrylonitrile.

9. The battery tray according to one of claims 2 to 8, wherein the seal is preformed.

10. The battery tray according to one of claims 2 to 9, wherein the seal is disposed at the edge of the area of overlapping and is not compressed by the action of the structural blind rivets.

11. The battery tray according to one of claims 2 to 9, wherein the seal is disposed in the area of overlapping between the first and the second plate and is compressed by the action of the structural blind rivets.

12. A method of manufacturing a sealed battery tray (1) for an alkaline electrolyte battery (51, 52, 53, 54) comprising a plate assembly (30, 31, 32, 33, 34), which method comprises the steps of:
- providing a first metal plate (32) provided with a series of holes in an area of overlapping;
- providing a second metal plate (30) provided with a series of holes intended to be positioned facing those of the first metal plate in the area of overlapping, the two plates being intended to overlap in the area of overlapping;
- assembling the two plates in the area of overlapping using structural blind rivets each having a head (85a), a shank (85b) and upset head (85c) so that the head and upset head of the structural blind rivets abut against a surface of each plate extending beyond the surface area of each hole, and whereby the shank of the structural blind rivets is deformed so as to substantially occupy in a sealed manner the entire volume of said holes of the first and second plates.

13. The method according to claim 12, comprising a step of placing an elastomeric seal (71) comprising a material selected from a butyl rubber, an ethylene-propylene-diene terpolymer and a nitrile rubber, wherein said seal is disposed with continuity at the area of overlapping, in continuous contact with the first and the second plate so as to complete the sealing of the battery tray.

14. The manufacturing method according to claim 12, wherein each metal plate is selected from:
- a flat plate;
- a folded plate;
- a shaped plate.
